# EUROPEAN PATENT APPLICATION

(11) **EP 4 671 856 A1**
(43) Date of publication of application: **31.12.2025**
(21) Application number: 25169101.0
(22) Date of filing: 08.04.2025
(51) Int. Cl.: G02F 1/03, H03K 19/0185, G02F 1/01, G02F 1/025

(54) **DRIVER FOR OPTICAL MODULATOR WITH PROGRAMMABLE BIAS**

(30) Priority: 28.06.2024 US 202418759495
(71) Applicant: Intel Corporation, Santa Clara, CA 95054 (US)
(72) Inventor: LEVY, Cooper, Portland, 97225 (US); SHARMA, Jahnavi, Portland, 97225 (US); BALAMURUGAN, Ganesh, Hillsboro, 97124 (US)
(74) Representative: Viering, Jentschura & Partner mbB Patent- und Rechtsanwälte

(57) **Abstract**

Embodiments herein relate to a driver circuit for an optical modulator such as a micro-ring modulator (MRM). The driver circuit includes first and second drivers which receive respective differential data signals, and which have their output nodes coupled to a cathode and anode, respectively of the MRM. One or both of the drivers can have their output nodes alternating-current (AC)-coupled to a bias circuit which biases the voltage of the output signal to shift its voltage swing. The bias circuit can include a latch which receives Vbc_high at its power supply terminal and Vbc_low at its ground terminal, where Vbc_high>Vbc_low>0 V.

## Description

### BACKGROUND

Optical communication systems offer many advantages including high bandwidth and low signal loss. In one approach, laser light is injected into a waveguide and has its intensity, phase, or wavelength modulated according to a data signal. For example, for intensity modulation, a resonant waveguide with a modulated wavelength is place adjacent to the waveguide to provide a coupling between the light in the waveguide and the resonant waveguide. However, various challenges are presented in operating an optical communication system.

### BRIEF DESCRIPTION OF THE DRAWINGS

The embodiments of the disclosure will be understood more fully from the detailed description given below and from the accompanying drawings of various embodiments of the disclosure, which, however, should not be taken to limit the disclosure to the specific embodiments, but are for explanation and understanding only.
FIG. 1A depicts an example implementation of an optical communication system 100, in accordance with various embodiments.
FIG. 1B depicts a top-down view of an example implementation of the micro-ring modulator (MRM) 150 of FIG. 1A, in accordance with various embodiments.
FIG. 2 depicts an example implementation of the driver 121 of FIG. 1A as a stacked driver 200, in accordance with various embodiments.
FIG. 3 depicts an example implementation of the driver 121 of FIG. 1A as a direct current (DC)-coupled pseudo-differential driver 300, in accordance with various embodiments.
FIG. 4 depicts an example implementation of the driver 121 of FIG. 1A as an alternating current (AC)-coupled pseudo-differential driver 400, in accordance with various embodiments.
FIG. 5 depicts an example implementation of the driver 121 of FIG. 1A in a low-power, high-swing optical driver circuit 500, in accordance with various embodiments.
FIG. 6A depicts an example circuit 600 based on the driver circuit 500 of FIG. 5, where a first driver is AC-coupled to a respective latch and to a cathode of a MRM, and a second driver is AC-coupled to a respective latch and to an anode of the MRM, in accordance with various embodiments.
FIG. 6B depicts an example implementation of the inverter 623 of FIG. 6A, in accordance with various embodiments.
FIG. 6C depicts an example circuit 650 based on the driver circuit 500 of FIG. 5, where a first driver is AC-coupled to a respective latch and to a cathode of a MRM, and a second driver is direct current (DC)-coupled to an anode of the MRM, in accordance with various embodiments.
FIG. 7 depicts an example implementation of the driver circuit 500 of FIG. 5 with a resistive-based, AC-coupled bias at the output of the driver DRV1, in accordance with various embodiments.
FIG. 8A depicts an example implementation of the driver circuit 500 of FIG. 5, where a latch-based bias, AC-coupled bias at the output of the driver DRV1, in accordance with various embodiments.
FIG. 8B depicts another example implementation of the driver circuit of FIG. 8A, where a capacitor divider is added to reduce voltage swing, in accordance with various embodiments.
FIG. 9 depicts an example implementation of the circuit of FIG. 6A in a configuration for three-level pulse-amplitude modulation (PAM-3) signaling, in accordance with various embodiments.
FIG. 10 depicts an example implementation of the circuit of FIG. 6A in a configuration for four-level pulse-amplitude modulation (PAM-3) signaling, in accordance with various embodiments.
FIG. 11 depicts an example implementation of a circuit 1100 which adds photo current sensing to the bias circuit 620 of FIG. 6A, in accordance with various embodiments.
FIG. 12 depicts an example implementation of the driver DRV1 of FIG. 5 as an inverting amplifier with a single-polarity power supply, in accordance with various embodiments.
FIG. 13 depicts a flowchart of an example process for a driver circuit, in accordance with various embodiments.
FIG. 14 depicts an eye diagram which demonstrates a reduced spread when optimizing Vbc_low and Vbc_high in the circuit of FIG. 6A, in accordance with various embodiments.
FIG. 15A depicts an eye diagram for the driver circuit of FIG. 7, in accordance with various embodiments.
FIG. 15B depicts an eye diagram for the driver circuit of FIG. 8A, in accordance with various embodiments.
FIG. 16 illustrates an example of components that may be present in a computing system 1650 for implementing the techniques (e.g., operations, processes, methods, and methodologies) described herein.

### DETAILED DESCRIPTION

As mentioned at the outset, various challenges are presented in operating an optical communication system.

One example system uses a micro-ring modulator (MRM) which includes a circular or other ring-shaped waveguide coupled to a straight waveguide. The ring resonator supports specific resonant wavelengths where the light circulates within the ring. When the input light of the straight waveguide matches one of these resonant wavelengths, it couples into the ring and can be modulated. The modulation is achieved by altering the refractive index of the ring waveguide material, usually through electro-optic effects. This change in refractive index shifts the resonant wavelength, thereby modulating the light signal passing through the straight waveguide.

The modulator driver can be implemented in a complementary metal-oxide semiconductor (CMOS) chip/integrated circuit, for example. The driver applies a varying voltage to the cathode and anode terminals of the modulator based on the data to be carried. Generally, it is desirable for the driver to have a high voltage swing.

Specifically, electrical drivers for MRMs typically have requirements for both relatively high drive voltage (e.g., >1.5V peak-to-peak), as well as a high direct current (DC) reverse-bias (e.g., -1 to -3 V) on the pn-junction of the modulator. Meeting these MRM drive/bias requirements is challenging in scaled CMOS technologies, which can deliver power efficiency and integration benefits.

In one approach to achieving a high-swing optical modulator in CMOS, a differential or pseudo-differential driver is direct current (DC)-coupled to the two terminals of the optical modulator. A pseudo-differential driver is a type of circuit or device used to drive differential signal lines. Unlike a true differential driver, which drives two complementary signals that are referenced to each other, a pseudo-differential driver drives one signal referenced to a common ground and another complementary signal. This approach doubles the swing seen at the modulator, with all devices/transistors operating from the nominal supply voltage. DC-coupling a differential driver to the MRM sets the DC bias voltage of the MRM at roughly 0 V. Unfortunately, MRMs have low bandwidth at 0 V bias and typically need a reverse bias of 1-3 V to deliver the bandwidth necessary for 50+GBaud signaling.

In another approach, a cascoded or stacked driver operates with a supply voltage of two times (2Vdd) the nominal voltage for high-speed devices. This style of driver can be DC-coupled to one terminal of the optical modulator and the other terminal can be connected to a high-voltage DC bias. While simple in terms of implementation, the high supply voltage leads to excess power dissipation. For identical device size, the power consumption of a stacked driver is roughly twice that of a differential driver due to charging and discharging the capacitive load of the optical modulator, pads, electro-static discharge (ESD), and driver parasitics. For equivalent resistor-capacitor (RC) bandwidth and swing, the device size for a stacked driver is almost double that of a differential driver. This also increases pre-driver power.

In another approach, a driver such as a differential or stacked driver is AC-coupled to the optical modulator. Following AC coupling capacitors, the required DC bias voltage for the optical modulator can be applied through large resistors. While AC coupling separates the optical modulator bias from its swing, many applications demand a low-frequency cutoff of <200 kHz to support long run-length patterns such as a Pseudo-Random Binary Sequence of length 2^31-1 bits (PRBS31). Ideally, operation to DC (~0 Hz) is desirable. However, the resistor and AC-coupling capacitor sizes required to meet these constraints are prohibitively large, precluding on-chip integration.

The solutions provided herein address the above and other disadvantages. In one aspect, a pseudo-differential AC-coupled driver and a DC-coupled latch are used to provide a data signal-dependent biasing, giving the power and bandwidth benefits of a differential driver, while addressing biasing requirements for a high-bandwidth MRM with <200 kHz low-frequency cutoff, for instance. The latch uses the fast edge rates of digital data, even for low baud-rate signals, to set the MRM bias. The biasing circuit has significantly lower bandwidth requirements than the AC-coupled signal path, and consumes negligible power, allowing use of low-speed, high-voltage devices without affecting performance or power.

The solutions provide a number of advantages. For example, the driver maintains high swing, while also providing signal-dependent bias at lower power than other drivers. Maintaining high swing and large optical modulator bias voltage allows for high optical modulation amplitude (OMA), extinction ratio (ER), and high bandwidth. Providing a signal-dependent bias overcomes the limitation of a typical AC-coupled driver, extending bandwidth to DC or near DC. Providing this style of driver in a differential format also helps to minimize the overall transmitter power.

These and other features will be further apparent in view of the following discussion.

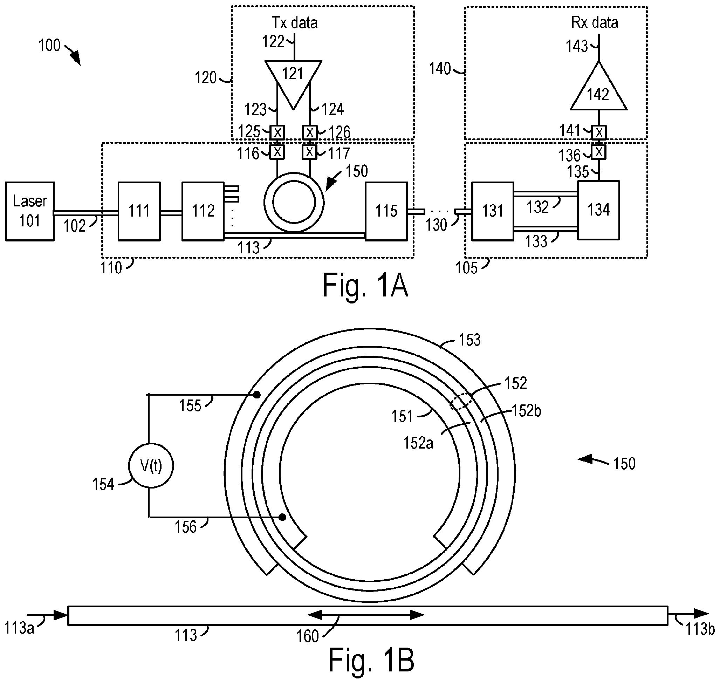

FIG. 1A depicts an example implementation of an optical communication system 100, in accordance with various embodiments. The system includes a laser 101, a silicon photonics transmitter chip 110 which is driven by a CMOS transmitter chip 120, and a silicon photonics receiver chip 105 which is coupled to a CMOS receiver chip 140.

The laser injects light in an optical fiber 102. In a silicon photonics transmitter chip 110, a vertical fiber grating coupler 111 is used to optically couple the light to a splitter 112 which outputs multiple optical channels. An example channel in a straight on-chip waveguide 113 is adjacent to a MRM 150. In the chip 120, a CMOS chip transmitter driver 121 receives data for transmission (Tx data) on an input path 122 and provides corresponding first and second parts of a differential signal on paths 123 and 124, respectively, to a cathode and anode, respectively, of the MRM, to drive the MRM. The differential signal parts are provided via pads 125 and 126 on the chip 120 and pads 116 and 117, respectively, on the chip 110. In one approach, a bond wire connects the pads. In another approach, such as in a flip-chip configuration, solder balls connect the pads.

The modulated light in the MRM is coupled to the light in the waveguide 113 to provide modulated light to an edge coupler 115 and then via an optical fiber 130 to a vertical fiber grating coupler 131 of a silicon photonics receiver chip 105.

The modulated light is an optical data stream that can be coupled to the photonics chip of the receiving package using a polarization-diversity scheme (with transverse electric (TE) and transverse magnetic (TM) components on paths 132 and 133), and fed into a Ge-based photodetector 134, which converts the optical data into a modulated current on a path 135. Finally, the current-based data stream is converted into a digital data stream by a dedicated receiver amplifier 142 on the chip 140. The modulated current is provided from the chip 105 to the chip 140 via pads 136 and 141. The amplifier 142 outputs received data (Rx data) on a path 143.

FIG. 1B depicts a top-down view of an example implementation of the micro-ring modulator (MRM) 150 of FIG. 1A, in accordance with various embodiments. The MRM includes an inner p+ doped region 151, a central waveguide 152, and an outer n+ doped region 153 formed on a buried oxide layer, which in turn is on a silicon layer, for example. In one possible approach, the ring extends laterally on the chip, and the waveguide is formed from adjacent p and n type regions 152a and 152b, respectively. The p+ doped and n+ doped regions are formed adjacent to the p and n type regions, respectively. The MRM may have a diameter of about 10-20 µm, for instance. The ring can be circular, oval or other ring or loop shape which allows resonance. The arrow 160 depicts a coupling zone in which the light in the waveguide 113 and the light in the MRM 150 interact. The input light of the waveguide (arrow 113a) is modulated by the MRM in the coupled zone to provide a corresponding modulated output light (arrow 113b).

A driver 154 provides a time-varying voltage V(t) which includes a cathode voltage on a path 155 coupled to the outer n+ doped region 153, and an anode voltage on a path 156 coupled to the inner p+ doped region 151.

Note that the while an MRM is depicted, the solutions provided herein can be used with any optical modulator. For example, any optical modulator that has a primarily capacitive impedance can be used such as an Electro-Absorption Modulator (EAM), one example of which is a Mach-Zehnder modulator. For modulators that have a primarily resistive impedance, it is difficult to supply the required DC current.

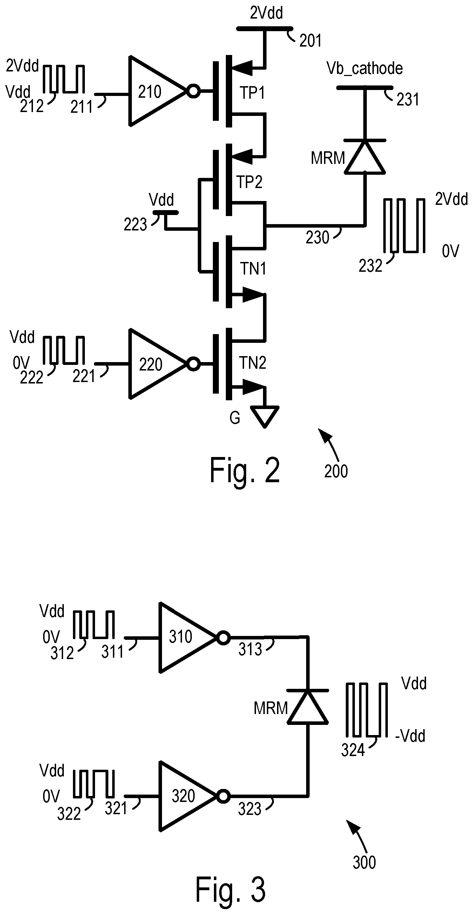

FIG. 2 depicts an example implementation of the driver 121 of FIG. 1A as a stacked driver 200, in accordance with various embodiments. As mentioned, a cascoded or stacked driver operates with a supply voltage of two times (2Vdd) the nominal voltage for high-speed devices. The driver can be DC-coupled to one terminal of the optical modulator and the other terminal can be connected to a high-voltage DC bias. However, the high supply voltage leads to excess power dissipation.

The driver 121 includes, in series, a power supply node 201 at 2Vdd, p-type metal-oxide-semiconductor field-effect transistors (pMOSFETs or pMOSs) TP1 and TP2, n-type MOSFETs (nMOSFETs or nMOSs) TN1 and TN2 and a ground node G. The control gate of TP1 is driven by the output of an inverting amplifier 210, which receives a differential data signal 212 with a voltage swing of Vdd to 2Vdd at its input 211. The control gate of TN2 is driven by the output of an inverting amplifier 220, which receives a differential data signal 222 with a voltage swing of 0 V to Vdd at its input 221. A power supply node 223 at Vdd is coupled to the control gates of TP2 and TN1. The output 230 of the driver carries a signal 232 with a voltage swing of 0 V to 2Vdd. The signal is coupled to an MRM, which in turn is biased by a power supply node 231 at a cathode voltage of VB_cathode. The MRM is represented as a diode.

FIG. 3 depicts an example implementation of the driver 121 of FIG. 1A as a direct current (DC)-coupled pseudo-differential driver 300, in accordance with various embodiments. As mentioned, a differential or pseudo-differential driver can be DC-coupled to the two terminals of the optical modulator. The driver 300 includes an inverting amplifier 310 whose output 313 provides a cathode voltage of the MRM, and an inverting amplifier 320 whose output 323 provides an anode voltage of the MRM. The inverting amplifiers 310 and 320 receive differential data signals 312 and 322, respectively, on their inputs 311 and 321, respectively. Both differential data signals have a voltage swing of 0 V to Vdd The corresponding output signal 324 has a voltage swing of -Vdd to Vdd.

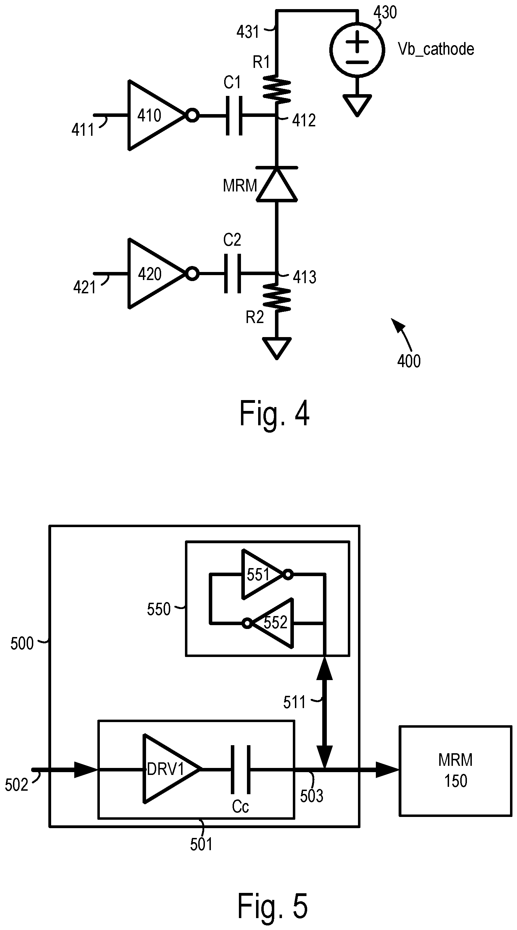

FIG. 4 depicts an example implementation of the driver 121 of FIG. 1A as an alternating current (AC)-coupled pseudo-differential driver 400, in accordance with various embodiments. As mentioned, a pseudo-differential driver can be AC-coupled to the MRM, e.g., by providing capacitors C1 and C2 at the outputs of the inverting amplifiers 410 and 420, respectively, which receive differential data signals at their inputs 411 and 421, respectively. C1 is coupled to the cathode side of the MRM at a node 412, and C2 is coupled to the anode side of the MRM at a node 413. The node 412 is also coupled via a resistor R1 on a path 431 to a voltage source 430 which provides a voltage Vb_cathode. The node 413 is coupled to ground via a resistor R2.

FIG. 5 depicts an example implementation of the driver 121 of FIG. 1A in a low-power, high-swing optical driver circuit 500, in accordance with various embodiments. The driver includes two paths. A first path 501 is a high-speed path which is AC-coupled, allowing ac-combining of multiple high-speed, low-swing paths to achieve high-swing at high speed. The second path 511 is a low-speed, high-voltage path that is DC-coupled to the output, allowing the high DC bias voltage of the optical modulator 150 to be set using lower-speed, high voltage devices. High speed refers to high frequency and low speed refers to low frequency, e.g., lower than the high frequency.

For non-return-to-zero (NRZ) signaling, the desired NRZ digital levels of the driver can be maintained, even for low-frequency signals, with bit rates significantly lower than the cutoff frequency of the high-speed AC-coupled path. The AC/DC combining solution ensures the high-pass and low-pass poles occur at the same frequency. Gain matching between the two paths is achieved by the use of highly-digital drivers, which have output swings defined by their supply voltages.

In particular, the first path 501 includes a driver DRV1 having an input 502 to receive a data signal. The output of DRV1 is coupled to an output path 503 and the MRM 150 or other optical modulator via a coupling capacitor Cc. The second path 511 couples a bias circuit 550 to the output path 503. The bias circuit can include a latch having a pair of cross-coupled inverters 551 and 552, for example. The latch acts as a bias circuit to bias the signal on the output path 503. The bias circuit 550 can include other components such as voltage sources and resistors, discussed further below.

DRV1 can be an inverting amplifier which is designed to increase the power of the incoming signal and/or isolating the input signal from the output of the amplifier.

The implementation of FIG. 5 provides a simplified view of a single signal path. In some implementations, two paths for parts of a differential signal can be used.

The circuit is also compatible with transmitter feedforward equalization (FFE).

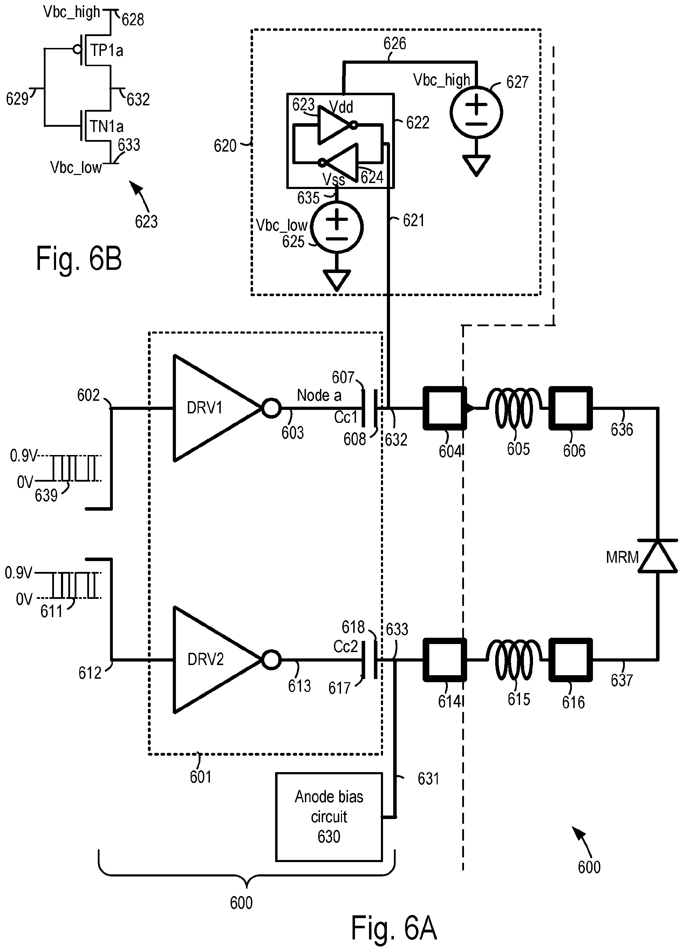

FIG. 6A depicts an example circuit 600 based on the driver circuit 500 of FIG. 5, where a first driver DRV1 is AC-coupled to a respective latch and to a cathode of a MRM, and a second driver DRV2 is AC-coupled to a respective latch and to an anode of the MRM, in accordance with various embodiments. The high-speed pseudo-differential path 601 includes first and second drivers, DRV1 and DRV2, respectively, such as CMOS inverting amplifiers. DRV1 receives a first differential data signal 639 at an input node 602, and DRV2 receives a second differential data signal 611 at an input node 612. The input signals may have a common voltage swing such as 0 V to a maximum level such as 0.9 V, for example. The second differential input signal may be an inverse or complement of the first differential input signal. DRV1 and DRV2 can be considered to be cathode and anode drivers, respectively.

An output node 603 of DRV1 is coupled to an input side 607 of a first capacitor Cc1 and an output node 613 of DRV2 is coupled to an input side 617 of a second capacitor Cc2. An output side 608 of Cc1 is coupled to a cathode bias circuit 620 via an output path 632 and a bias path 621, and an output side 618 of Cc2 is coupled to an anode bias circuit 630 via an output path 633 and a bias path 631. The cathode bias circuit 620 includes a latch 622 and voltage sources 627 and 625 which provide positive voltages Vbc_high and Vbc_low, respectively, via paths 626 and 635, respectively, to the power supply terminal and ground terminal, respectively, of the inverters 623 and 624, respectively, of the latch, where Vbc_high>Vbc_low>0 V. The voltage sources can be voltage regulators, for example. Vdd and Vss in the latch 622 represent the power supply terminal and ground terminal, respectively. Vbc_high and Vbc_low are first and second positive voltages, respectively. The second positive voltage may be greater than the supply voltage Vdd, in one approach. For most applications Vbc_low can be between 1-2 V, for example. Vbc_high can be 1.9-2.9 V, for example. Vbc_high is approximately Vbc_low+Vdd.

In one possible implementation, the cathode bias circuit 620 changes the voltage swing of the output signal of DRV1 from 0 V to the maximum of the signal 639 (Vmax) to a range within Vbc_low to Vbc_high. Similarly, the anode bias circuit 630 can change the voltage swing of the output signal of DRV2 from 0 V to Vmax of the signal 611 to a range within Vba_low to Vba_high. Vba_low and Vba_high can be 0 V and Vdd, respectively, for example, but they could be other values if desired.

The modified signal on the output path 632 is provided to a bond pad 604 of a CMOS transmitter/driver chip to a bond pad 606 of a silicon photonics chip via a bond wire 605, for example, which is depicted as an inductor. The bond pad 606 provides the signal on a path 636 as the cathode voltage of the MRM. Similarly, the modified signal on the output path 633 is provided to a bond pad 614 of the CMOS transmitter/driver chip to a bond pad 616 of a silicon photonics chip via a bond wire 615, for example. The bond pad 616 provides the signal on the path 637 as the anode voltage of the MRM.

The components to the left of the long-dashed line may be part of a CMOS transmitter/driver chip and the components to the right of the long-dashed line may be part of a silicon photonics chip, in one possible implementation.

The anode bias circuit may be similar to the cathode bias circuit but with different voltage sources. For example, voltage sources in the anode bias circuit may include voltage sources which provide voltages of Va_high and Va_low to the power supply terminal and ground terminal, respectively, of the inverters of the latch. In one possible approach, Vbc_high=Vba_high and/or Vbc_low=Vba_low.

The drivers DRV1 and DVR2 are shown as CMOS inverters but could also be implemented as stacked high-voltage CMOS drivers, for example.

The low-speed bias path can be implemented as a DC-coupled latch operated between two bias voltages, Vbc_high and Vbc_low for the cathode side, which nominally differ by the supply voltage of the technology (e.g., Vbc_high-Vbc_low≈Vdd). Assuming a balanced non-return-to-zero (NRZ) data pattern, the average of Vbc_high and Vbc_low is the desired DC bias voltage for the respective node (e.g., (Vbc_high+Vbc_low)/2=Vbias_cathode and (Vba_high+Vba_low)/2=Vbias_anode). The inverters in the low-speed bias path are near minimum size, with the only requirement being that the signal on the output path 632 is capable of tracking the signal on DRV1's output node 603 in normal operation.

FIG. 6B depicts an example implementation of the inverter 623 of FIG. 6A, in accordance with various embodiments. The inverter may be a CMOS inverter which includes, in series, a power supply terminal 628 at Vbc_high, a pMOS TP1a, an output path 632, an nMOS TN1a, and a ground terminal at Vbc_low. An input node 629 is also depicted. The other inverter 624 of the latch 622 can be configured similarly with Vbc_high and Vbc_low at its power supply terminal and ground terminal, respectively.

The inverters of a corresponding latch in the anode bias circuit 630 can be configured similarly with Vac_high and Vac_low at their power supply terminals and ground terminals, respectively.

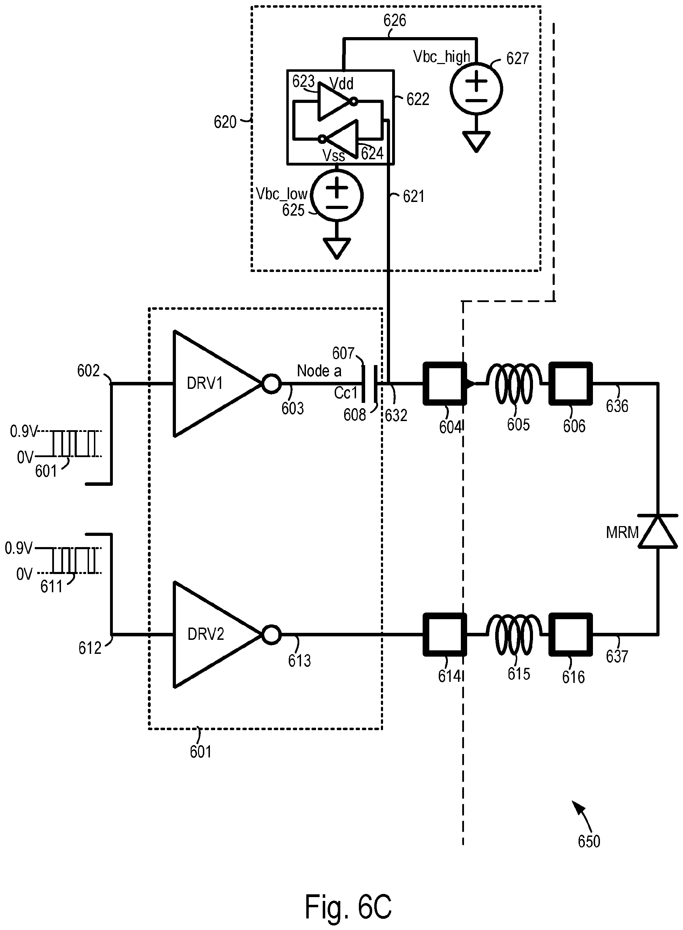

FIG. 6C depicts an example circuit 650 based on the driver circuit 500 of FIG. 5, where a first driver is AC-coupled to a respective latch and to a cathode of a MRM, and a second driver is direct current (DC)-coupled to an anode of the MRM, in accordance with various embodiments. In the circuit of FIG. 6A, the output signals of the cathode and anode drivers were AC-coupled by a capacitor and biased by respective bias circuits. Optionally, the output of only one of the cathode and anode drivers is AC-coupled and biased by a respective bias circuit. For example, here, the output of only the cathode driver DRV1 on the output path 632 is AC-coupled and biased by a respective bias circuit. The output of the anode driver DRV2 on the output node 613 is DC-coupled to the cathode of the MRM.

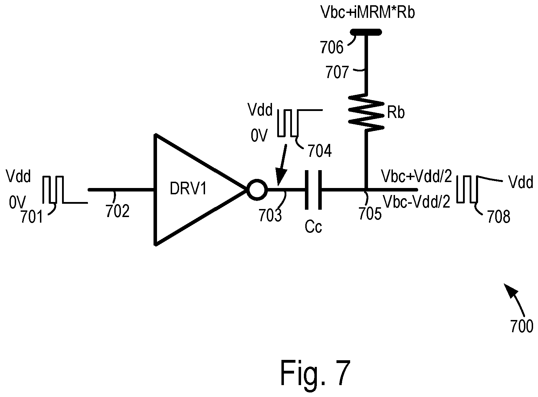

FIG. 7 depicts an example implementation of the driver circuit 500 of FIG. 5 with a resistive-based, AC-coupled bias at the output of the driver DRV1, in accordance with various embodiments. The circuit 700 includes DRV1 which receives a signal 701 having a voltage swing of 0 V to Vdd on an input node 702. An output node 703 of DRV1 carries a signal 704 which also has a voltage swing of 0 V to Vdd, but is an inverse of the signal 701. The output node 703 is coupled to an output path 705 via a capacitor Cc. The output path is biased by a path 707 which includes a resistor Rb and a power supply node 706 having a voltage of Vbc+iMRM*Rb. iMRM is a leakage current of the MRM which is represented as a diode, as mentioned.

The biased signal 708 on the output path has a voltage swing of Vbc-Vdd/2 to Vbc+Vdd/2. However, without the latch, this AC-coupled driver exhibits undesired settling due to low frequency cutoff.

In this approach, a bias voltage Vbc that sets the operating point of the optical modulator is provided through Rb. For high-frequency data, the signal passes as desired, but with a long string of the same symbol, the voltage after Cc begins to droop as depicted in the signal 708, approaching Vbc if the driver output is constant for much longer than the time constant of Cc and Rb.

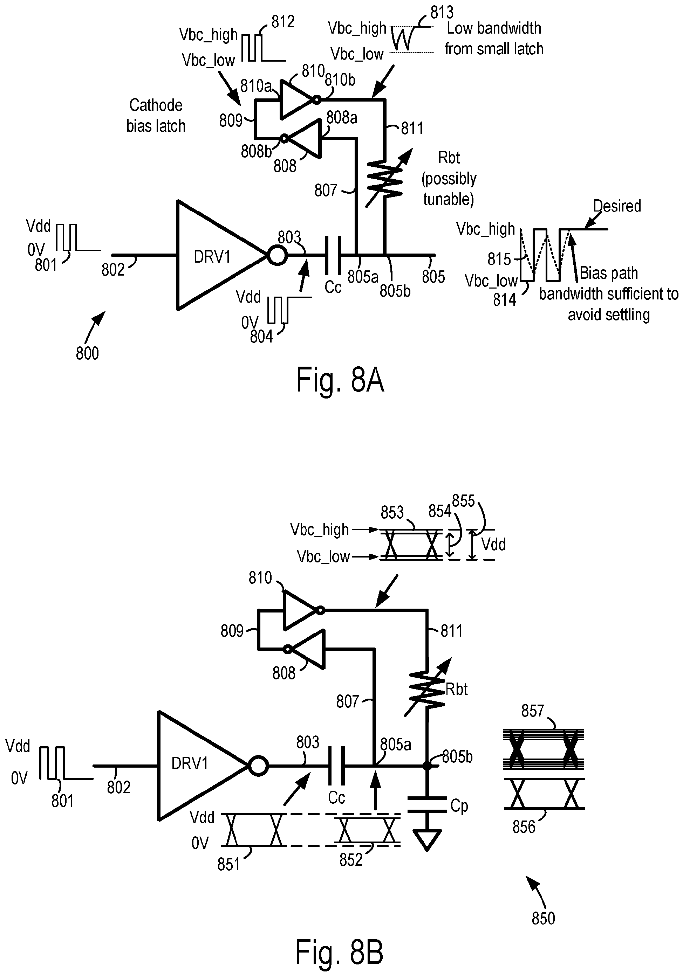

FIG. 8A depicts an example implementation of the driver circuit 500 of FIG. 5, where a latch-based bias, AC-coupled bias at the output of the driver DRV1, in accordance with various embodiments. The circuit 800 includes DRV1 which receives a signal 801 having a voltage swing of 0 V to Vdd on an input node 802. An output node 803 of DRV1 carries a signal 804 which also has a voltage swing of 0 V to Vdd, but is an inverse of the signal 801. The output node 803 is coupled to a first node 805a of an output path 805 via a capacitor Cc. The first node 805a is coupled via a path 807 to the input 808a of a first inverter 808. An output 808b of the first inverter 808 is coupled by a path 809 to the input 810a of a second inverter 810. An output 810b of the second inverter 810 is coupled by a path 811 and a tunable/programmable resistor Rbt to a second node 805b of the output path 805. The first node is between the output side of the capacitor and the second node. Note that nodes 805a and 805b are drawn as being separate but could be the same point.

A signal 812 on the path 809 has a voltage swing between Vbc_low and Vbc_high. A signal 813 on the path 811 also has a voltage swing between Vbc_low and Vbc_high. An output signal 814 on the output path 805 represents a desired signal (the inverse of signal 812), which also has a voltage swing between Vbc_low and Vbc _high, while the signal 815 represents the actual signal. 0 V to Vdd is a first voltage swing and Vbc_low to Vbc_high is a second voltage swing which is no greater than the first voltage swing, in one approach. In one approach, Vbc_high >Vdd. In another approach, Vbc_low is also >Vdd.

In this approach, instead of the fixed bias (Vbc) of FIG. 7, the low-speed bias path provides a signal-dependent bias. That is, the bias at the node 805b (an output of the bias circuit) is a function of the output signal on the path 807 (an input to the bias circuit). Even though the bandwidth of the bias path may be lower than the high-speed path, as illustrated by the waveforms (signal 813) that settle relatively slowly at path 811, as long as the signal 813 settles faster than the time constant of Rb and Cc, the signal-dependent bias voltage will prevent the output from having the undesired settling of other approaches. The signal-dependent bias of the proposed solution involves matching the swing/gain of the bias path to the high-speed path.

The series resistor Rbt is added to control the output impedance of the low-speed path. Since the latch inverters may be quite small, and nominally the output path 805 is driven by the high-speed path at an edge transition of the associated signal, there is minimal power drawn by the low-speed path inverters. Hence, the power requirements for the bias supplies are quite minimal, allowing for the biases to be generated from low-speed, high-voltage circuits, adding minimal power consumption to the driver. The bias voltages could be generated from a resistor ladder digital-to-analog converter (DAC), programmable or fixed voltage regulators, or any other means of generating a bias voltage, which is capable of supplying a small current (e.g., a few hundreds of microamps).

FIG. 8B depicts another example implementation of the driver circuit of FIG. 8A, where a capacitor divider is added to reduce voltage swing, in accordance with various embodiments. The circuit 850 is similar to the circuit 800 of FIG. 8A but includes a parasitic capacitance Cp of the devices and interconnects which forms a capacitor divider with the first capacitor Cc. Cp is coupled at one side to the node 805b and at the other side to ground. Additionally, eye diagrams are shown at various locations in the circuit. An eye diagram is an oscilloscope display in which a digital signal from a receiver is repetitively sampled and applied to the vertical input, while the data rate is used to trigger the horizontal sweep. The eye diagrams 851 and 852 represent the signals at the output node 803 and the first node 805a, respectively. The swing of the signal at the output node 803 is reduced by the capacitor divider according to the ratio Cc/(Cc+Cp).

The eye diagram 853 represents the signal at the path 811. The bias circuit reduces the biases to match the capacitor divider attenuation of the high-speed path. The arrow 855 represents the initial voltage swing of Vbc_low to Vbc_high (≈Vdd) and the arrow 854 represents the reduced voltage swing (<Vdd). The eye diagram 856 is for the output signal on the output node 805b Vbc_low and Vbc_high are properly adjusted and has a voltage swing corresponding to the arrow 854. The eye diagram 856 is cleaned up in this case. In contrast, the eye diagram 857 is for the case where Vbc_low and Vbc_high are not properly adjusted. The eye diagram 857 represents a "fuzzy" eye, or eye closure due to the difference in eye heights shown by the eye diagrams 851 and 852.

With the AC-coupling capacitor (Cc) and parasitic capacitances that follow (Cp), the signal from the high-speed path is slightly attenuated. If the difference between Vbc_high and Vbc_low is Vdd, low-frequency content will have a larger amplitude than high-frequency content at the output, leading to inter-symbol interference (ISI). If the difference between Vbc_high and Vbc_low is reduced to match the swing of the high-speed path after the coupling capacitor (at node 805a), a clean eye diagram with no low-frequency ISI can be achieved.

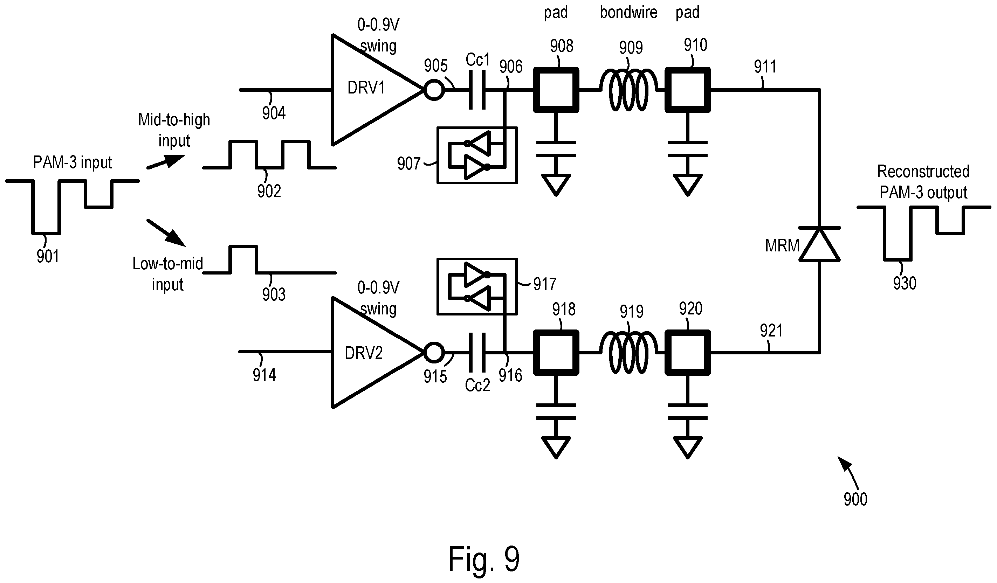

FIG. 9 depicts an example implementation of the circuit of FIG. 6A in a configuration for PAM3 signaling, in accordance with various embodiments. The proposed driver can be extended from binary signaling formats such as NRZ, amplitude-shift keying (ASK), frequency-shift keying (FSK) or phase-shift keying (PSK) to support multi-level modulation formats such as PAM3 and PAM4. As shown in FIG. 9, independently controlling the cathode and anode drivers, DRV1 and DRV2, can generate a PAM-3 output.

PAM-3 uses three voltage levels: a high level, a low level, and a zero level in the middle. The PAM-3 input signal 901 comprises a signal 902 representing the mid-to-high input and a signal 903 representing the low-to-mid input. The signals 902 and 903 may have a common voltage swing such as 0 V to a maximum level such as 0.9 V, for example.

The signal 902 is received at the input node 904 of DRV1. A corresponding inverted output is provided at the output node 905 and AC-coupled by a first capacitor Cc1 to provide a signal at a node 906 which is biased by a cathode bias circuit 907. The biased signal is provided from the node 906 to the bond pad 908, and then the bond pad 910 via the bond wire 909, and then via a cathode path 911 to the MRM.

Similarly, the signal 903 is received at the input node 914 of DRV2. A corresponding inverted output is provided at the output node 915 and AC-coupled by a second capacitor Cc2 to provide a signal at a node 916 which is biased by an anode bias circuit 917. The biased signal is provided from the node 916 to the bond pad 918, and then the bond pad 920 via the bond wire 919, and then via an anode path 921 to the MRM. The signal 930 represents the signal applied to the MRM and corresponds to the PAM-3 input signal 901.

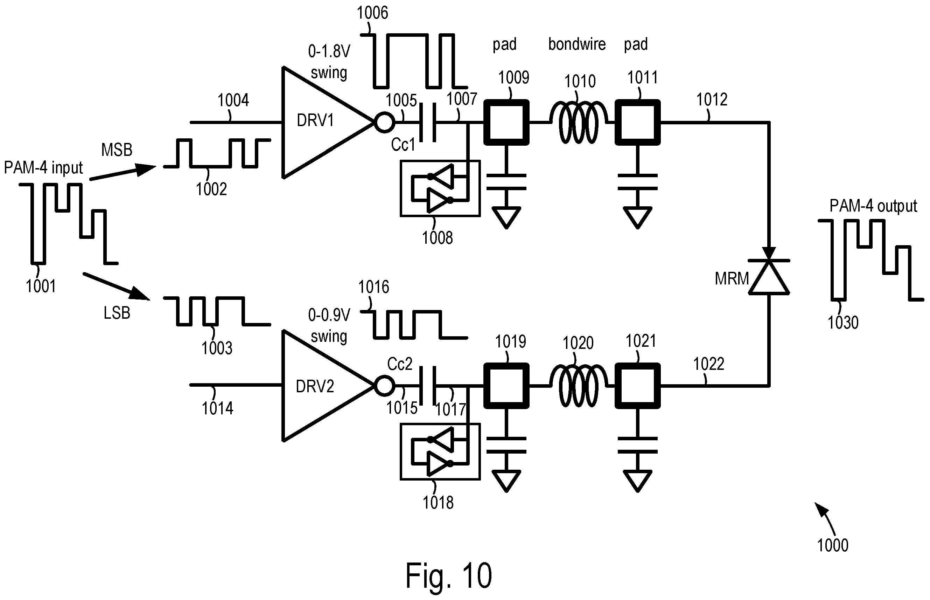

FIG. 10 depicts an example implementation of the circuit of FIG. 6A in a configuration for PAM4 signaling, in accordance with various embodiments. PAM4 uses four discrete signal levels, with each representing 2 bits of information. One channel transmits the least significant bit (LSB) and the other transmits the most significant bit (MSB). The LSB has half the amplitude of the MSB. The PAM-4 input signal 1001 comprises a signal 1002 representing the MSB and a signal 1003 representing the LSB. For example, the MSB signals 1002 may have a voltage swing which is twice that of the LSB signal 1003. The driver DRV1 can be modified compared to the PAM-3 circuit of FIG. 9 to similarly have a larger voltage swing than DRV2. By modifying the driver to have differing swings on the anode and cathode paths, PAM4 modulation can be realized. For example, the cathode driver DRV1 can have a higher voltage swing, e.g., twice as high, as the anode drive DRV2. The high-swing driver can use a stacked inverter driver configuration while the low-swing driver can use a non-stacked inverter driver configuration, for example.

The signal 1002 is received at the input node 1004 of DRV1. A corresponding inverted output is provided at the output node 1005 and AC-coupled by a first capacitor Cc1 to provide a signal 1006 at a node 1007 which is biased by a cathode bias circuit 1008. The biased signal is provided from the node 1007 to the bond pad 1009, and then the bond pad 1011 via the bond wire 1010, and then via a cathode path 1012 to the MRM.

Similarly, the signal 1003 is received at the input node 1014 of DRV2. A corresponding inverted output is provided at the output node 1015 and AC-coupled by a second capacitor Cc2 to provide a signal 1016 at a node 1017 which is biased by a cathode bias circuit 1018. The biased signal is provided from the node 1017 to the bond pad 1019, and then the bond pad 1021 via the bond wire 1020, and then via a cathode path 1022 to the MRM. The signal 1030 represents the signal applied to the MRM and corresponds to the PAM-4 input signal 1001.

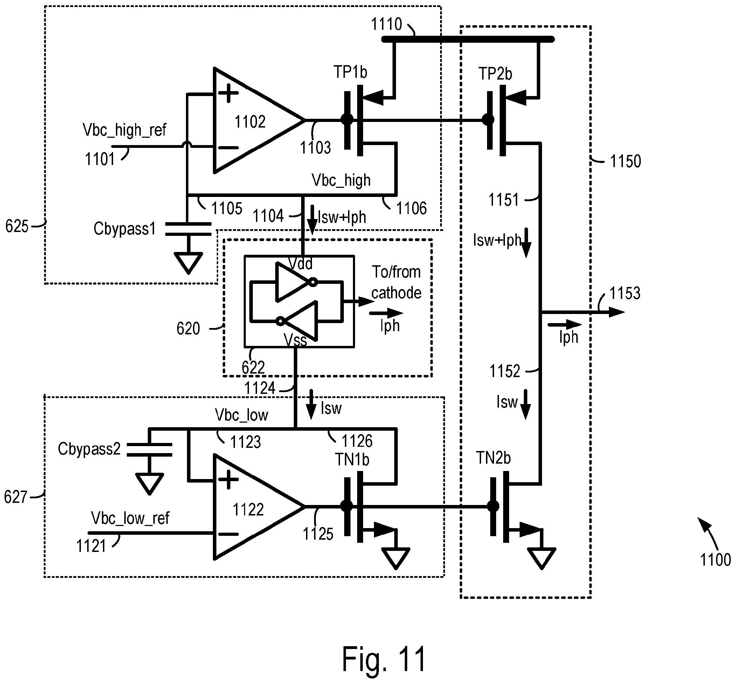

FIG. 11 depicts an example implementation of a circuit 1100 which adds photo current sensing to the bias circuit 620 of FIG. 6A, in accordance with various embodiments. The ability to sense MRM photocurrent (Iph) is useful as it enables efficient thermal tuning of the MRM. The circuit 1100 provides one possible technique for photocurrent sensing. While the low-speed cathode bias path carries signal information, it also provides the DC photocurrent to the MRM. If the supply voltages for this path are generated with LDO (low-dropout) voltage regulators (VRs) as shown, the high-side LDO supplies the low-speed path switching current as well as MRM photocurrent, while the low-side LDO VR only sinks low-speed path switching current. By making replicas of the LDO output transconductance devices, a replica current path is used to sense the difference in current supplied by the two LDOs, i.e., the photocurrent (Iph).

The circuit 1100 includes the Vb_high voltage source 625, the Vbc_low voltage source 627, and the latch 622 of FIG. 6A, in addition to a replica current path 1150. A reference current Vbc_high_ref is provided on an inverting path 1101 of a first comparator 1102. The non-inverting input of the comparator 1102 is coupled to ground via a first bypass capacitor, Cbypass1 and to a power supply terminal 1104 of the latches via a path 1105. An output node 1103 of the comparator 1102 is coupled to a control gate of a pMOS TP1b which in turn has a source coupled to a power supply node 1110 at Vdd and a drain coupled to the power supply terminal 1104 via a path 1106. A current Isw+Iph is generated or sourced at the power supply terminal 1104.

A reference current Vbc_low_ref is provided on an inverting path 1121 of a second comparator 1122. The non-inverting input of the comparator 1122 is coupled to ground via a second bypass capacitor, Cbypass2 and to a ground supply terminal 1124 of the latches via a path 1123. An output node 1125 of the comparator 1122 is coupled to a control gate of an nMOS TN1b which in turn has a source coupled to a ground node at 0 V and a drain coupled to the ground terminal 1124 via a path 1126. A current Isw is sunk at the ground supply terminal 1124. With Isw+Iph as the sourced current and Isw as the sunk current at the bias circuit 620, Iph is the current output to or from the cathode.

The replica current path 1150 includes a pMOS TP2b having a source coupled to the power supply node 1110 and a drain coupled to a path 1151 which carries Isw+Iph, and an nMOS TN2b having a source coupled to ground at 0 V and a drain coupled to a path 1152 which carries Isw. An output path 1153 coupled to the paths 1151 and 1152 carries the difference between these two currents, or Iph. Iph can be provided to a control circuit for use in thermal tuning of the MRM as the low-frequency photocurrent replica.

Note that the current sensing can be used with the cathode or anode driver of the MRM. This example uses the cathode driver.

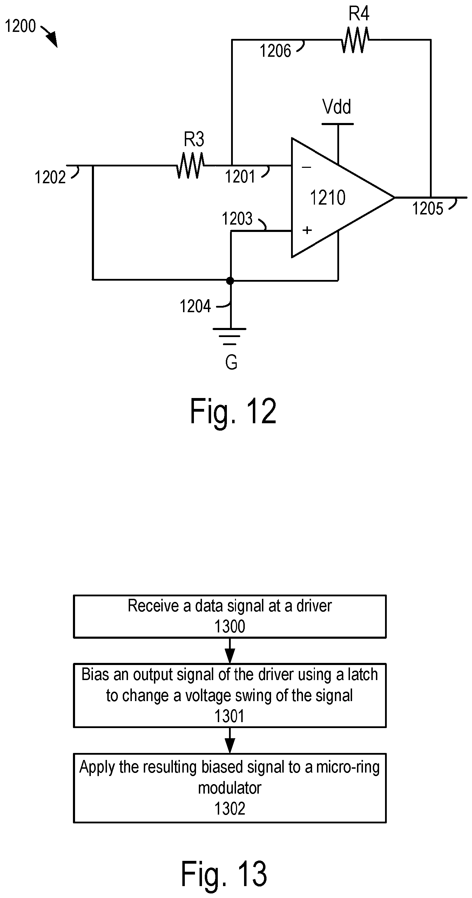

FIG. 12 depicts an example implementation of the driver DRV1 of FIG. 5 as an inverting amplifier with a single-polarity power supply, in accordance with various embodiments. The driver 1200 includes an inverting operational amplifier 1210 (op amp) having an inverting input 1201 which receive a data signal (e.g., a differential data signal) via an input path 1202 and a resistor R3. The op amp also includes a non-inverting input 1203 which is coupled to ground, e.g., 0 V, via a path 1204. An output node 1205 of the op amp and the inverting input 1201 are coupled by a feedback path 1206 which includes a resistor R4. The op amp can be a CMOS inverting amplifier, for example.

FIG. 13 depicts a flowchart of an example process for a driver circuit, in accordance with various embodiments. An operation 1300 includes receiving a data signal at a driver. For example, this can be a differential data signal in a cathode or anode driving path of a circuit. An operation 1301 includes biasing an output signal of the driver using a latch to change a voltage swing of the signal. An operation 1302 includes applying the resulting biased signal to a micro-ring modulator, e.g., as a cathode or anode voltage. The process can optionally be performed concurrently in two differential data paths, as mentioned.

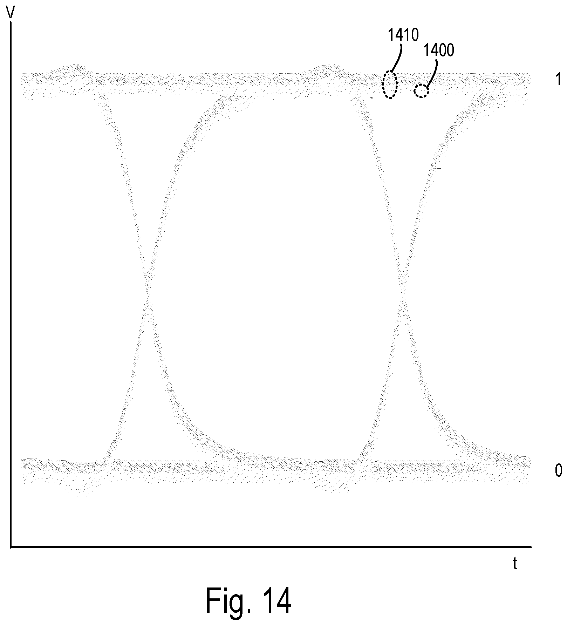

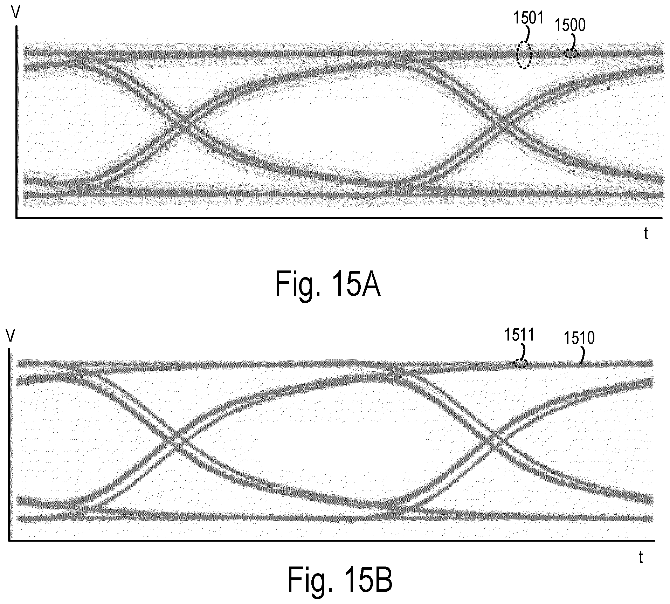

FIG. 14 depicts an eye diagram which demonstrates a reduced spread when optimizing Vbc_low and Vbc_high in the circuit of FIG. 6A, in accordance with various embodiments. An eye diagram is an oscilloscope display in which a digital signal from a receiver is repetitively sampled and applied to the vertical input, while the data rate is used to trigger the horizontal sweep. In FIGs. 14, 15A and 15B, the vertical axis depicts voltage and the horizontal axis depicts time. The eye diagrams 1400 and 1410 depict a driver output signal with and without biasing, respectively. The use of the biasing circuits are described herein result in a significant reduction in the line width (shown at the data "1" level), corresponding to a reduction in distortion and an increase in signal-to-noise ratio.

The eye diagram is simulated and is for the cathode side of the driver. It shows that reducing the supply voltage for the latch successfully reduces the ISI at the driver output.

Compared to a stacked driver, the proposed pseudo-differential driver also provides improved performance and/or reduced power consumption. By removing the cascoded devices from the stacked driver, with equivalent device sizing, the RC time constant of the load improves by almost a factor of two. This is due to improved transconductance/on-resistance of the device and reduced drain parasitic capacitance. This improved performance can be traded for reduced power by decreasing the size of the driver devices.

FIG. 15A depicts an eye diagram for the driver circuit of FIG. 7, in accordance with various embodiments. The driver circuit in this example includes a resistive-based, AC-coupled bias at the output of the driver DRV1. The plots 1500 and 1501 represent the results with a Pseudo-Random Binary Sequence of length 2^10-1 bits (PRBS10) pattern and a Short Stress Pattern Random (SSPR), respectively. SSPR is a short pattern with a similar stress as random data. There is a significant degradation in the eye pattern with the SSPR compared to the PRBS10 with the resistively-based design.

FIG. 15B depicts an eye diagram for the driver circuit of FIG. 8A, in accordance with various embodiments. The driver circuit in this example includes a latch-based bias, AC-coupled bias at the output of the driver DRV1. The plots 1510 and 1511 represent the results with the PRBS10 pattern and the SSPR, respectively. Here, there is almost no degradation with the SSPR compared to the PRBS10. The two eye diagrams are essentially overlapping.

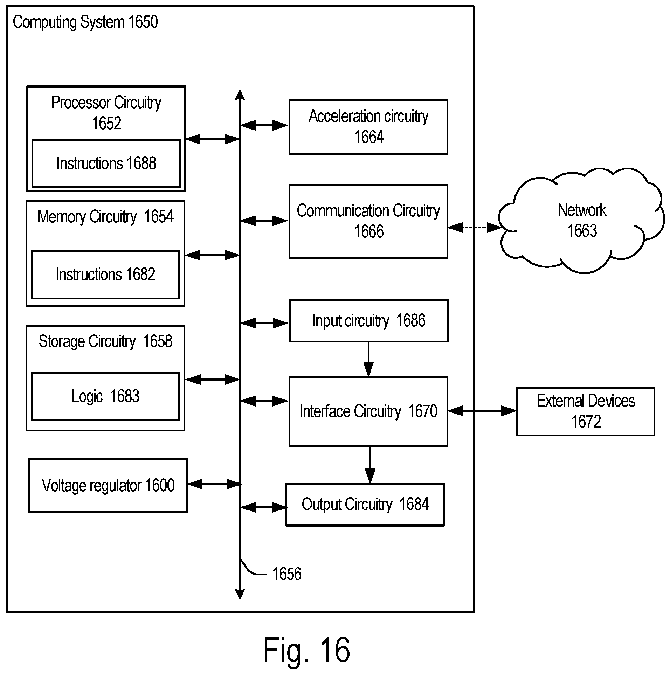

FIG. 16 illustrates an example of components that may be present in a computing system 1650 for implementing the techniques (e.g., operations, processes, methods, and methodologies) described herein.

The computing system 1650 may include any combinations of the hardware or logical components referenced herein. The components may be implemented as ICs, portions thereof, discrete electronic devices, or other modules, instruction sets, programmable logic or algorithms, hardware, hardware accelerators, software, firmware, or a combination thereof adapted in the computing system 1650, or as components otherwise incorporated within a chassis of a larger system. In an example implementation, the communication circuitry 1666 includes the CMOS transmitter chip 120 and silicon photonics transmitter chip 110 of FIG. 1A. The communication circuitry 1666 can include the circuit 500, 600, 650, 700, 800, 850, 900, 1000, for example. In one approach, all or part of the computing system 1650 is provided in a SoP, System in Package (SiP) or a System on Chip (SoC).

The voltage regulator can provide a voltage Vout to one or more of the components of the computing system 1650. The memory circuitry 1654 may store instructions and the processor circuitry 1652 may execute the instructions to perform the functions described herein.

The system 1650 includes processor circuitry in the form of one or more processors 1652. The processor circuitry 1652 includes circuitry such as, but not limited to one or more processor cores and one or more of cache memory, low drop-out voltage regulators (LDOs), interrupt controllers, serial interfaces such as SPI, I2C or universal programmable serial interface circuit, real time clock (RTC), timer-counters including interval and watchdog timers, general purpose I/O, memory card controllers such as secure digital/multi-media card (SD/MMC) or similar, interfaces, mobile industry processor interface (MIPI) interfaces and Joint Test Access Group (JTAG) test access ports. In some implementations, the processor circuitry 1652 may include one or more hardware accelerators (e.g., same or similar to acceleration circuitry 1664), which may be microprocessors, programmable processing devices (e.g., FPGA, ASIC, etc.), or the like. The one or more accelerators may include, for example, computer vision and/or deep learning accelerators. In some implementations, the processor circuitry 1652 may include on-chip memory circuitry, which may include any suitable volatile and/or non-volatile memory, such as DRAM, SRAM, EPROM, EEPROM, Flash memory, solid-state memory, and/or any other type of memory device technology, such as those discussed herein

The processor circuitry 1652 may include, for example, one or more processor cores (CPUs), application processors, GPUs, RISC processors, Acorn RISC Machine (ARM) processors, CISC processors, one or more DSPs, one or more FPGAs, one or more PLDs, one or more ASICs, one or more baseband processors, one or more radio-frequency integrated circuits (RFIC), one or more microprocessors or controllers, a multi-core processor, a multithreaded processor, an ultra-low-voltage processor, an embedded processor, or any other known processing elements, or any suitable combination thereof. The processors (or cores) 1652 may be coupled with or may include memory/storage and may be configured to execute instructions stored in the memory/storage to enable various applications or operating systems to run on the platform 1650. The processors (or cores) 1652 is configured to operate application software to provide a specific service to a user of the platform 1650. In some embodiments, the processor(s) 1652 may be a special-purpose processor(s)/controller(s) configured (or configurable) to operate according to the various embodiments herein.

As examples, the processor(s) 1652 may include an Intel^{®} Architecture Core^{™} based processor such as an i3, an i5, an i7, an i9 based processor; an Intel^{®} microcontroller-based processor such as a Quark^{™}, an Atom^{™}, or other MCU-based processor; Pentium^{®} processor(s), Xeon^{®} processor(s), or another such processor available from Intel^{®} Corporation, Santa Clara, California. However, any number other processors may be used, such as one or more of Advanced Micro Devices (AMD) Zen^{®} Architecture such as Ryzen^{®} or EPYC^{®} processor(s), Accelerated Processing Units (APUs), MxGPUs, Epyc^{®} processor(s), or the like; A5-A12 and/or S1-S4 processor(s) from Apple^{®} Inc., Snapdragon^{™} or Centriq^{™} processor(s) from Qualcomm^{®} Technologies, Inc., Texas Instruments, Inc.^{®} Open Multimedia Applications Platform (OMAP)^{™} processor(s); a MIPS-based design from MIPS Technologies, Inc. such as MIPS Warrior M-class, Warrior I-class, and Warrior P-class processors; an ARM-based design licensed from ARM Holdings, Ltd., such as the ARM Cortex-A, Cortex-R, and Cortex-M family of processors; the ThunderX2^{®} provided by Cavium^{™}, Inc.; or the like. In some implementations, the processor(s) 1652 may be a part of a system on a chip (SoC), System-in-Package (SiP), a multi-chip package (MCP), and/or the like, in which the processor(s) 1652 and other components are formed into a single integrated circuit, or a single package, such as the Edison^{™} or Galileo^{™} SoC boards from Intel^{®} Corporation. Other examples of the processor(s) 1652 are mentioned elsewhere in the present disclosure.

The system 1650 may include or be coupled to acceleration circuitry 1664, which may be embodied by one or more AI/ML accelerators, a neural compute stick, neuromorphic hardware, an FPGA, an arrangement of GPUs, one or more SoCs (including programmable SoCs), one or more CPUs, one or more digital signal processors, dedicated ASICs (including programmable ASICs), PLDs such as complex (CPLDs) or high complexity PLDs (HCPLDs), and/or other forms of specialized processors or circuitry designed to accomplish one or more specialized tasks. These tasks may include AI/ML processing (e.g., including training, inferencing, and classification operations), visual data processing, network data processing, object detection, rule analysis, or the like. In FPGA-based implementations, the acceleration circuitry 1664 may comprise logic blocks or logic fabric and other interconnected resources that may be programmed (configured) to perform various functions, such as the procedures, methods, functions, etc. of the various embodiments discussed herein. In such implementations, the acceleration circuitry 1664 may also include memory cells (e.g., EPROM, EEPROM, flash memory, static memory (e.g., SRAM, anti-fuses, etc.) used to store logic blocks, logic fabric, data, etc. in LUTs and the like.

In some implementations, the processor circuitry 1652 and/or acceleration circuitry 1664 may include hardware elements specifically tailored for machine learning and/or artificial intelligence (AI) functionality. In these implementations, the processor circuitry 1652 and/or acceleration circuitry 1664 may be, or may include, an AI engine chip that can run many different kinds of AI instruction sets once loaded with the appropriate weightings and training code. Additionally or alternatively, the processor circuitry 1652 and/or acceleration circuitry 1664 may be, or may include, AI accelerator(s), which may be one or more of the aforementioned hardware accelerators designed for hardware acceleration of AI applications. As examples, these processor(s) or accelerators may be a cluster of artificial intelligence (AI) GPUs, tensor processing units (TPUs) developed by Google^{®} Inc., Real AI Processors (RAPs^{™}) provided by AlphaICs^{®}, Nervana^{™} Neural Network Processors (NNPs) provided by Intel^{®} Corp., Intel^{®} Movidius^{™} Myriad^{™} X Vision Processing Unit (VPU), NVIDIA^{®} PX^{™} based GPUs, the NM500 chip provided by General Vision^{®}, Hardware 3 provided by Tesla^{®}, Inc., an Epiphany^{™} based processor provided by Adapteva^{®}, or the like. In some embodiments, the processor circuitry 1652 and/or acceleration circuitry 1664 and/or hardware accelerator circuitry may be implemented as AI accelerating co-processor(s), such as the Hexagon 685 DSP provided by Qualcomm^{®}, the PowerVR 2NX Neural Net Accelerator (NNA) provided by Imagination Technologies Limited^{®}, the Neural Engine core within the Apple^{®} A11 or A12 Bionic SoC, the Neural Processing Unit (NPU) within the HiSilicon Kirin provided by Huawei^{®}, and/or the like. In some hardware-based implementations, individual subsystems of system 1650 may be operated by the respective AI accelerating co-processor(s), AI GPUs, TPUs, or hardware accelerators (e.g., FPGAs, ASICs, DSPs, SoCs, etc.), etc., that are configured with appropriate logic blocks, bit stream(s), etc. to perform their respective functions.

The system 1650 also includes system memory 1654. Any number of memory devices may be used to provide for a given amount of system memory. As examples, the memory 1654 may be, or include, volatile memory such as random access memory (RAM), static RAM (SRAM), dynamic RAM (DRAM), synchronous DRAM (SDRAM), RAMBUS^{®} Dynamic Random Access Memory (RDRAM^{®}), and/or any other desired type of volatile memory device. Additionally or alternatively, the memory 1654 may be, or include, non-volatile memory such as read-only memory (ROM), erasable programmable ROM (EPROM), electrically erasable programmable (EEPROM), flash memory, non-volatile RAM, ferroelectric RAM, phase-change memory (PCM), flash memory, and/or any other desired type of non-volatile memory device. Access to the memory 1654 is controlled by a memory controller. The individual memory devices may be of any number of different package types such as single die package (SDP), dual die package (DDP) or quad die package (Q17P). Any number of other memory implementations may be used, such as dual inline memory modules (DIMMs) of different varieties including but not limited to microDIMMs or MiniDIMMs.

Storage circuitry 1658 provides persistent storage of information such as data, applications, operating systems and so forth. In an example, the storage 1658 may be implemented via a solid-state disk drive (SSDD) and/or high-speed electrically erasable memory (commonly referred to as "flash memory"). Other devices that may be used for the storage 1658 include flash memory cards, such as SD cards, microSD cards, XD picture cards, and the like, and USB flash drives. In an example, the memory device may be or may include memory devices that use chalcogenide glass, multi-threshold level NAND flash memory, NOR flash memory, single or multi-level Phase Change Memory (PCM), a resistive memory, nanowire memory, ferroelectric transistor random access memory (FeTRAM), anti-ferroelectric memory, magnetoresistive random access memory (MRAM) memory that incorporates memristor technology, phase change RAM (PRAM), resistive memory including the metal oxide base, the oxygen vacancy base and the conductive bridge Random Access Memory (CB-RAM), or spin transfer torque (STT)-MRAM, a spintronic magnetic junction memory based device, a magnetic tunneling junction (MTJ) based device, a Domain Wall (DW) and Spin Orbit Transfer (SOT) based device, a thyristor based memory device, a hard disk drive (HDD), micro HDD, of a combination thereof, and/or any other memory. The memory circuitry 1654 and/or storage circuitry 1658 may also incorporate three-dimensional (3D) cross-point (XPOINT) memories from Intel^{®} and Micron^{®}.

The memory circuitry 1654 and/or storage circuitry 1658 is/are configured to store computational logic 1683 in the form of software, firmware, microcode, or hardware-level instructions to implement the techniques described herein. The computational logic 1683 may be employed to store working copies and/or permanent copies of programming instructions, or data to create the programming instructions, for the operation of various components of system 1650 (e.g., drivers, libraries, application programming interfaces (APIs), etc.), an operating system of system 1650, one or more applications, and/or for carrying out the embodiments discussed herein. The computational logic 1683 may be stored or loaded into memory circuitry 1654 as instructions 1682, or data to create the instructions 1682, which are then accessed for execution by the processor circuitry 1652 to carry out the functions described herein. The processor circuitry 1652 and/or the acceleration circuitry 1664 accesses the memory circuitry 1654 and/or the storage circuitry 1658 over the interconnect (IX) 1656. The instructions 1682 direct the processor circuitry 1652 to perform a specific sequence or flow of actions, for example, as described with respect to flowchart(s) and block diagram(s) of operations and functionality depicted previously. The various elements may be implemented by assembler instructions supported by processor circuitry 1652 or high-level languages that may be compiled into instructions 1688, or data to create the instructions 1688, to be executed by the processor circuitry 1652. The permanent copy of the programming instructions may be placed into persistent storage devices of storage circuitry 1658 in the factory or in the field through, for example, a distribution medium (not shown), through a communication interface (e.g., from a distribution server (not shown)), over-the-air (OTA), or any combination thereof.

The IX 1656 couples the processor 1652 to communication circuitry 1666 for communications with other devices, such as a remote server (not shown) and the like. The communication circuitry 1666 is a hardware element, or collection of hardware elements, used to communicate over one or more networks 1663 and/or with other devices. In one example, communication circuitry 1666 is, or includes, transceiver circuitry configured to enable wireless communications using any number of frequencies and protocols such as, for example, the Institute of Electrical and Electronics Engineers (IEEE) 802.11 (and/or variants thereof), IEEE 802.23.4, Bluetooth^{®} and/or Bluetooth^{®} low energy (BLE), ZigBee^{®}, LoRaWAN^{™} (Long Range Wide Area Network), a cellular protocol such as 3GPP LTE and/or Fifth Generation (5G)/New Radio (NR), and/or the like. Additionally or alternatively, communication circuitry 1666 is, or includes, one or more network interface controllers (NICs) to enable wired communication using, for example, an Ethernet connection, Controller Area Network (CAN), Local Interconnect Network (LIN), DeviceNet, ControlNet, Data Highway+, or PROFINET, among many others.

The IX 1656 also couples the processor 1652 to interface circuitry 1670 that is used to connect system 1650 with one or more external devices 1672. The external devices 1672 may include, for example, sensors, actuators, positioning circuitry (e.g., global navigation satellite system (GNSS)/Global Positioning System (GPS) circuitry), client devices, servers, network appliances (e.g., switches, hubs, routers, etc.), integrated photonics devices (e.g., optical neural network (ONN) integrated circuit (IC) and/or the like), and/or other like devices.

In some optional examples, various input/output (I/O) devices may be present within or connected to, the system 1650, which are referred to as input circuitry 1686 and output circuitry 1684. The input circuitry 1686 and output circuitry 1684 include one or more user interfaces designed to enable user interaction with the platform 1650 and/or peripheral component interfaces designed to enable peripheral component interaction with the platform 1650. Input circuitry 1686 may include any physical or virtual means for accepting an input including, inter alia, one or more physical or virtual buttons (e.g., a reset button), a physical keyboard, keypad, mouse, touchpad, touchscreen, microphones, scanner, headset, and/or the like. The output circuitry 1684 may be included to show information or otherwise convey information, such as sensor readings, actuator position(s), or other like information. Data and/or graphics may be displayed on one or more user interface components of the output circuitry 1684. Output circuitry 1684 may include any number and/or combinations of audio or visual display, including, inter alia, one or more simple visual outputs/indicators (e.g., binary status indicators (e.g., light emitting diodes (LEDs)) and multi-character visual outputs, or more complex outputs such as display devices or touchscreens (e.g., Liquid Crystal Displays (LCD), LED displays, quantum dot displays, projectors, etc.), with the output of characters, graphics, multimedia objects, and the like being generated or produced from the operation of the platform 1650. The output circuitry 1684 may also include speakers and/or other audio emitting devices, printer(s), and/or the like. Additionally or alternatively, sensor(s) may be used as the input circuitry 1684 (e.g., an image capture device, motion capture device, or the like) and one or more actuators may be used as the output device circuitry 1684 (e.g., an actuator to provide haptic feedback or the like). Peripheral component interfaces may include, but are not limited to, a non-volatile memory port, a USB port, an audio jack, a power supply interface, etc. In some embodiments, a display or console hardware, in the context of the present system, may be used to provide output and receive input of an edge computing system; to manage components or services of an edge computing system; identify a state of an edge computing component or service; or to conduct any other number of management or administration functions or service use cases.

The components of the system 1650 may communicate over the IX 1656. The IX 1656 may include any number of technologies, including ISA, extended ISA, I2C, SPI, point-to-point interfaces, power management bus (PMBus), PCI, PCIe, PCIx, Intel^{®} UPI, Intel^{®} Accelerator Link, Intel^{®} CXL, CAPI, OpenCAPI, Intel^{®} QPI, UPI, Intel^{®} OPA IX, RapidIO^{™} system IXs, CCIX, Gen-Z Consortium IXs, a HyperTransport interconnect, NVLink provided by NVIDIA^{®}, a Time-Trigger Protocol (TTP) system, a FlexRay system, PROFIBUS, and/or any number of other IX technologies. The IX 1656 may be a proprietary bus, for example, used in a SoC based system.

The number, capability, and/or capacity of the elements of system 1650 may vary, depending on whether computing system 1650 is used as a stationary computing device (e.g., a server computer in a data center, a workstation, a desktop computer, etc.) or a mobile computing device (e.g., a smartphone, tablet computing device, laptop computer, game console, IoT device, etc.). In various implementations, the computing device system 1650 may comprise one or more components of a data center, a desktop computer, a workstation, a laptop, a smartphone, a tablet, a digital camera, a smart appliance, a smart home hub, a network appliance, and/or any other device/system that processes data.

The techniques described herein can be performed partially or wholly by software or other instructions provided in a machine-readable storage medium (e.g., memory). The software is stored as processor-executable instructions (e.g., instructions to implement any other processes discussed herein). Instructions associated with the flowchart (and/or various embodiments) and executed to implement embodiments of the disclosed subject matter may be implemented as part of an operating system or a specific application, component, program, object, module, routine, or other sequence of instructions or organization of sequences of instructions.

The storage medium can be a tangible, non-transitory machine readable medium such as read only memory (ROM), random access memory (RAM), flash memory devices, floppy and other removable disks, magnetic storage media, optical storage media (e.g., Compact Disk Read-Only Memory (CD ROMS), Digital Versatile Disks (DVDs)), among others.

The storage medium may be included, e.g., in a communication device, a computing device, a network device, a personal digital assistant, a manufacturing tool, a mobile communication device, a cellular phone, a notebook computer, a tablet, a game console, a set top box, an embedded system, a TV (television), or a personal desktop computer.

Some non-limiting examples of various embodiments are presented below.

Example 1 includes an apparatus, comprising: a driver comprising an input node and an output node; a capacitor having an input side coupled to the output node and an output side coupled to an output path; a latch coupled to the output path, wherein the latch comprises a first inverter having an input node coupled to the output path and a second inverter having an input node coupled to an output node of the first inverter and an output node coupled to the output path; a high-voltage source coupled to power supply terminals of the first and second inverters; and a low-voltage source coupled to ground terminals of the first and second inverters, wherein the high-voltage source is configured to provide a first positive voltage, and the low-voltage source is configured to provide a second positive voltage which is lower than the first positive voltage.

Example 2 includes the apparatus of Example 1, wherein: the input node of the first inverter is coupled to a first node of the output path; the output node of the second inverter is coupled to a second node of the output path; and the first node is between the output side of the capacitor and the second node.

Example 3 includes the apparatus of Example 1 or 2, wherein the first and second inverters each comprise a complementary metal-oxide semiconductor (CMOS) inverter.

Example 4 includes the apparatus of any one of Examples 1-3, further comprising a tunable resistor, wherein the output node of the second inverter is coupled to the output path via the tunable resistor.

Example 5 includes the apparatus of any one of Examples 1-4, wherein the capacitor is a first capacitor, and the apparatus further comprises a parasitic capacitance coupled to the output path and a ground to form a capacitor divider with the first capacitor.

Example 6 includes the apparatus of any one of Examples 1-5, wherein: the input node of the driver is to receive a signal with a first voltage swing between 0 V and a supply voltage Vdd; and the latch is to provide a corresponding signal on the output path with a second voltage swing between the first and second voltages.

Example 7 includes the apparatus of any one of Examples 1-6, wherein the output path is coupled to a cathode or anode of an optical modulator.

Example 8 includes the apparatus of Example 7, wherein: the driver, the capacitor and the latch are on a complementary metal-oxide semiconductor (CMOS) chip; and the optical modulator is on a silicon photonics chip.

Example 9 includes the apparatus of Example 7, wherein the driver, the capacitor, the latch and the optical modulator are on a common die.

Example 10 includes the apparatus of any one of Examples 1-9, wherein the driver is a first driver which is to receive a first part of a differential signal, the output path is a first output path, the latch is a first latch, and the apparatus further comprises: a second driver which is to receive a second part of the differential signal; a capacitor having an input side coupled to an output node of the second driver and an output side coupled to a second output path; and a second latch coupled to the second output path.

Example 11 includes the apparatus of any one of Examples 1-10, further comprising a replica current path coupled to the high-voltage source and the low-voltage source, wherein the replica current path comprises: a first path which is to carry a replica of a first current sourced by the high-voltage source; a second path which is to carry a replica of a second current sunk by the low-voltage source; and a third path coupled to the first and second path, wherein the third path is to carry a third current which is a difference between the first and second currents.

Example 12 includes an apparatus, comprising: a first driver to receive a first part of a differential signal, wherein an output node of the first driver is coupled to a cathode of an optical modulator; a second driver to receive a second part of the differential signal, wherein an output node of the second driver is coupled to an anode of the optical modulator; at least one of: a) a first latch which is alternating-current (AC)-coupled to the output node of the first driver, or a) a second latch which is AC-coupled to the output node of the second driver.

Example 13 includes the apparatus of Example 12, wherein the apparatus comprises the first latch and the second latch.

Example 14 includes the apparatus of Example 12 or 13, wherein: the apparatus comprises the first latch; and the output node of the second driver is direct-current (DC)-coupled to the anode of the optical modulator.

Example 15 includes the apparatus of any one of Examples 12-14, wherein: the apparatus comprises the second latch; and the output node of the first driver is direct-current (DC)-coupled to the cathode of the optical modulator.

Example 16 includes the apparatus of any one of Examples 12-15, further comprising: a first voltage source to provide a first positive voltage to a power supply terminal of at least one of the first or second latches; and a second voltage source to provide a second positive voltage to a ground terminal of at least one of the first or second latches, wherein the first positive voltage is greater than the second positive voltage.

Example 17 includes the apparatus of any one of Examples 12-16, wherein: the first driver is to receive a mid-to-high input of a three-level pulse-amplitude modulation (PAM-3) signal; the second driver is to receive a low-to-mid input of the PAM-3 signal; and the first and second drivers have a same voltage swing.

Example 18 includes the apparatus of any one of Examples 12-17, wherein: the first driver is to receive a MSB input of a four-level pulse-amplitude modulation (PAM-4) signal; the second driver is to receive an LSB input of the PAM-4 signal; and a voltage swing of the first driver is greater than a voltage swing of the second driver.

Example 19 includes a system, comprising: a complementary metal-oxide semiconductor (CMOS) chip comprising a driver and a latch which is coupled to an output path of the driver; and a silicon photonics chip comprising a micro-ring modulator, wherein the output path of the driver is coupled to a cathode or anode of the micro-ring modulator.

Example 20 includes the system of Example 19, wherein: the latch comprises a first inverter having an input node coupled to the output path and a second inverter having an input node coupled to an output node of the first inverter and an output node coupled to the output path; and the CMOS chip further comprises: a high-voltage source coupled to power supply terminals of the first and second inverters; and a low-voltage source coupled to ground terminals of the first and second inverters, wherein the high-voltage source is to provide a first positive voltage, and the low-voltage source is to provide a second positive voltage which is lower than the first positive voltage.

Example 21 includes a method for a driver circuit, comprising: receiving a data signal at the driver circuit; biasing an output signal of the driver using a latch to change a voltage swing of the signal; and applying the resulting biased signal to a micro-ring modulator as a cathode or anode voltage.

Example 22 include the method of Example 21, wherein the data signal comprises a differential data signal in a cathode or anode driving path of a circuit.

Example 23 includes an apparatus, comprising means to perform the method of Example 21 or 22.

Example 24 includes a machine-readable storage including machine-readable instructions which, when executed, cause a computer to implement the method of Example 21 or 22.

Example 25 includes a computer program comprising instructions which, when executed by a computer, cause the computer to carry out the method of Example 21 or 22.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order than the described embodiment. Various additional operations may be performed and/or described operations may be omitted in additional embodiments.

The terms "substantially," "close," "approximately," "near," and "about," generally refer to being within +/- 10% of a target value. Unless otherwise specified the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

For the purposes of the present disclosure, the phrases "A and/or B" and "A or B" mean (A), (B), or (A and B). For the purposes of the present disclosure, the phrase "A, B, and/or C" means (A), (B), (C), (A and B), (A and C), (B and C), or (A, B, and C).

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

As used herein, the term "circuitry" may refer to, be part of, or include an Application Specific Integrated Circuit (ASIC), an electronic circuit, a processor (shared, dedicated, or group), a combinational logic circuit, and/or other suitable hardware components that provide the described functionality. As used herein, "computer-implemented method" may refer to any method executed by one or more processors, a computer system having one or more processors, a mobile device such as a smartphone (which may include one or more processors), a tablet, a laptop computer, a set-top box, a gaming console, and so forth.

The terms "coupled," "communicatively coupled," along with derivatives thereof are used herein. The term "coupled" may mean two or more elements are in direct physical or electrical contact with one another, may mean that two or more elements indirectly contact each other but still cooperate or interact with each other, and/or may mean that one or more other elements are coupled or connected between the elements that are said to be coupled with each other. The term "directly coupled" may mean that two or more elements are in direct contact with one another. The term "communicatively coupled" may mean that two or more elements may be in contact with one another by a means of communication including through a wire or other interconnect connection, through a wireless communication channel or link, and/or the like.

Reference in the specification to "an embodiment," "one embodiment," "some embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that particular component, feature, structure, or characteristic is not required to be included. If the specification or claim refers to "a" or "an" element, that does not mean there is only one of the elements. If the specification or claims refer to "an additional" element, that does not preclude there being more than one of the additional elements.

Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

While the disclosure has been described in conjunction with specific embodiments thereof, many alternatives, modifications and variations of such embodiments will be apparent to those of ordinary skill in the art in light of the foregoing description. The embodiments of the disclosure are intended to embrace all such alternatives, modifications, and variations as to fall within the broad scope of the appended claims.

In addition, well-known power/ground connections to integrated circuit (IC) chips and other components may or may not be shown within the presented figures, for simplicity of illustration and discussion, and so as not to obscure the disclosure. Further, arrangements may be shown in block diagram form in order to avoid obscuring the disclosure, and also in view of the fact that specifics with respect to implementation of such block diagram arrangements are highly dependent upon the platform within which the present disclosure is to be implemented (i.e., such specifics should be well within purview of one skilled in the art). Where specific details (e.g., circuits) are set forth in order to describe example embodiments of the disclosure, it should be apparent to one skilled in the art that the disclosure can be practiced without, or with variation of, these specific details. The description is thus to be regarded as illustrative instead of limiting.

An abstract is provided that will allow the reader to ascertain the nature and gist of the technical disclosure. The abstract is submitted with the understanding that it will not be used to limit the scope or meaning of the claims. The following claims are hereby incorporated into the detailed description, with each claim standing on its own as a separate embodiment.

## Claims

1. An apparatus, comprising:
a driver comprising an input node and an output node;
a capacitor having an input side coupled to the output node and an output side coupled to an output path;
a latch coupled to the output path, wherein the latch comprises a first inverter having an input node coupled to the output path and a second inverter having an input node coupled to an output node of the first inverter and an output node coupled to the output path;
a high-voltage source coupled to power supply terminals of the first and second inverters; and
a low-voltage source coupled to ground terminals of the first and second inverters, wherein the high-voltage source is configured to provide a first positive voltage, and the low-voltage source is configured to provide a second positive voltage which is lower than the first positive voltage.

2. The apparatus of claim 1, wherein:
the input node of the first inverter is coupled to a first node of the output path;
the output node of the second inverter is coupled to a second node of the output path; and
the first node is between the output side of the capacitor and the second node.

3. The apparatus of claim 1 or 2, wherein the first and second inverters each comprise a complementary metal-oxide semiconductor (CMOS) inverter.

4. The apparatus of any one of claims 1-3, further comprising a tunable resistor, wherein the output node of the second inverter is coupled to the output path via the tunable resistor.

5. The apparatus of any one of claims 1-4, wherein the capacitor is a first capacitor, and the apparatus further comprises a parasitic capacitance coupled to the output path and a ground to form a capacitor divider with the first capacitor.

6. The apparatus of any one of claims 1-5, wherein:
the input node of the driver is to receive a signal with a first voltage swing between 0 V and a supply voltage Vdd; and
the latch is to provide a corresponding signal on the output path with a second voltage swing between the first and second voltages.

7. The apparatus of any one of claims 1-6, wherein the output path is coupled to a cathode or anode of an optical modulator.

8. The apparatus of claim 7, wherein:
the driver, the capacitor and the latch are on a complementary metal-oxide semiconductor (CMOS) chip; and
the optical modulator is on a silicon photonics chip.

9. The apparatus of claim 7 or 8, wherein the driver, the capacitor, the latch and the optical modulator are on a common die.

10. The apparatus of any one of claims 1-9, wherein the driver is a first driver which is to receive a first part of a differential signal, the output path is a first output path, the latch is a first latch, and the apparatus further comprises:
a second driver which is to receive a second part of the differential signal;
a capacitor having an input side coupled to an output node of the second driver and an output side coupled to a second output path; and
a second latch coupled to the second output path.

11. The apparatus of any one of claims 1-10, further comprising a replica current path coupled to the high-voltage source and the low-voltage source, wherein the replica current path comprises:
a first path which is to carry a replica of a first current sourced by the high-voltage source;
a second path which is to carry a replica of a second current sunk by the low-voltage source; and
a third path coupled to the first and second path, wherein the third path is to carry a third current which is a difference between the first and second currents.

12. A method for a driver circuit, comprising:
receiving a data signal at the driver circuit;
biasing an output signal of the driver using a latch to change a voltage swing of the signal; and
applying the resulting biased output signal to a micro-ring modulator as a cathode or anode voltage.

13. The method of claim 12, wherein the data signal comprises a differential data signal in a cathode or anode driving path of a circuit.

14. An apparatus, comprising means to perform the method of claim 12 or 13.

15. A machine-readable storage including machine-readable instructions which, when executed, cause a computer to implement the method of claim 12 or 13.
